# EUROPÄISCHE PATENTANMELDUNG

(11) **EP 2 023 698 A2**
(43) Veröffentlichungstag der Anmeldung: **11.02.2009**
(21) Anmeldenummer: 08011690.8
(22) Anmeldetag: 27.06.2008
(51) Int. Cl.: H05K 1/14

(54) **Verdrahtungsleiterplatte**

(30) Priorität: 09.08.2007 DE 202007011113 U
(71) Anmelder: MC Technology GmbH, 78176 Blumberg (DE)
(72) Erfinder: Müller, Karl, 78166 Donaueschingen/Heidenhofen (DE); Borst, Joachim, 78166 Donaueschingen (DE)
(74) Vertreter: Modrow, Stephanie

(57) **Zusammenfassung**

Verdrahtungsleiterplatte (40) zur Verbindung einer elektronischen Steuerung oder eines elektronischen Steuerungsmoduls (50) mit einer Anschlussleiterplatte (20), an welcher in Anschlussklemmen (22) Anschlussleitungen für die elektronische Steuerung oder das elektronische Steuerungsmodul (50) anschließbar sind, wobei die Verdrahtungsleiterplatte (40) einen Steckverbinder (42), welcher direkt oder über ein Verbindungskabel (30) in einen Gegenstecker (24) der Anschlussleiterplatte (20), welcher in elektrisch leitender Verbindung mit den Anschlussklemmen (22) der Anschlussleiterplatte (20) steht, einsteckbar ist, und wenigstens eine Steckfassung (44), in welche die elektronische Steuerung oder das elektronische Steuerungsmodul (50) einsteckbar ist, aufweist, wobei über die Verdrahtungsleiterplatte (40) der Steckverbinder (42) mit der wenigstens einen Steckfassung (44) elektrisch leitend verbunden ist.

## Beschreibung

Die Erfindung betrifft eine Verdrahtungsleiterplatte zur Verbindung einer elektronischen Steuerung oder eines elektronischen Steuerungsmoduls mit einer Anschlussleiterplatte, an welcher in Anschlussklemmen Anschlussleitungen für die elektronische Steuerung oder das elektronische Steuerungsmodul anschließbar sind.

Bei der Sanierung von Gebäuden müssen regelmäßig die Steuerungen der Gebäudeautomatisierung, bspw. Steuerungen von Türen, Jalousien, Heizungen oder Klimaanlagen, gegen modernere Steuerungen ausgetauscht werden. Bei den herkömmlichen Steuerungen sind bekannterweise zwei Baugruppen vorhanden, nämlich eine Anschlussleiterplatte, die Anschlussklemmen zum Anschluss von Anschlussleitungen aufweist, und eine Elektronikleiterplatte, die die eigentliche Steuerung umfasst. Die beiden Baugruppen sind in der Regel durch Steckverbinder oder steckbare Leitungen miteinander verbunden.

Nachteilig ist dabei, dass auf der Elektronikleiterplatte sämtliche Elektronikbausteine fest verdrahtet sind und daher bei Ausfall eines einzelnen Bausteines die gesamte elektronische Leiterplatte ausgetauscht werden muss. Allerdings werden heutzutage derartige Elektronikleiterplatten für ältere Geräte nicht mehr hergestellt. Die Elektronikleiterplatte wird heutzutage durch eine elektronische Steuerung oder einzelne Steuerungsmodule ersetzt. Um nun die herkömmlichen Steuerungen bei der Gebäudesanierung auszutauschen, ist es daher nötig, sämtliche Anschlussleitungen aus den Anschlussklemmen der Anschlussleiterplatten zu lösen und an den neuen Steuerungen oder Steuerungsmodulen neu anzuschließen. Dies erfordert viel Zeit, da an einer einzelnen Anschlussleiterplatte in der Regel eine Vielzahl von Anschlussleitungen, bspw. 100 oder 200 Anschlussleitungen, angeschlossen sind, was jedoch im laufenden Betrieb eines Gebäudes zu erheblichen Problemen führt, da während dieser Zeit die elektronischen Steuerungen außer Betrieb gesetzt werden müssen. Zudem besteht die Gefahr, dass die Anschlussleitungen vertauscht werden und daher die Steuerungen nach Wiederinbetriebnahme nicht richtig funktionieren.

Die Aufgabe der Erfindung besteht daher darin, eine Möglichkeit zu schaffen, den Austausch von Steuerungen in kurzer Zeit durchzuführen.

Die Aufgabe wird gelöst durch eine Verdrahtungsleiterplatte mit den Merkmalen des Schutzanspruchs 1.

Vorteilhafte Ausgestaltungen und Weiterbildungen der Erfindung sind in den Unteransprüchen angegeben.

Die Erfindung beruht auf der Erkenntnis, dass das Abklemmen der Anschlussleitungen von der Anschlussleiterplatte und der Neuanschluss dieser Anschlussleitungen besonders zeitaufwändig ist und somit vermieden werden sollte. Da heutzutage keine vollständigen Elektronikleiterplatten, die einen derartigen einfachen und wenig zeitaufwändigen Austausch ermöglichen würden, hergestellt werden, besteht die Erfindung darin, eine Verdrahtungsleiterplatte vorzusehen, welche über einen Steckverbinder in einen Gegenstecker der Anschlussleiterplatte einsteckbar ist und welche wenigstens eine Steckfassung aufweist, in welche die elektronische Steuerung oder die elektronischen Steuerungsmodule einsteckbar sind. Über die Verdrahtungsleiterplatte ist der Steckverbinder mit der wenigstens einen Steckfassung elektrisch leitend verbunden. Durch das Bereitstellen der Verdrahtungsleiterplatte, auf welcher Steckfassungen für bestimmte Steuerungen oder bestimmte Steuerungsmodule entsprechend mit dem Steckverbinder und über diesen mit den entsprechenden Anschlussklemmen auf der Anschlussleiterplatte elektrisch leitbar verbindbar sind, entfällt das Lösen der Verbindungen zwischen den Anschlussleitungen und den Anschlussklemmen auf der Anschlussleiterplatte, um die entsprechenden Anschlussleitungen direkt in die elektronische Steuerung oder das elektronische Steuerungsmodul anzuschließen. Ein Austausch der Elektronikleiterplatte gegen die Verdrahtungsleiterplatte, auf welche die entsprechenden elektronische Steuerungen oder elektronische Steuerungsmodule einsteckbar sind, kann in wesentlich kürzerer Zeit erfolgen, wobei Verdrahtungsfehler ausgeschlossen werden. Auch falls im Nachhinein einzelne Steuerungsmodule oder die elektronische Steuerung ausfallen sollten, können dann die Steuerung oder die Steuerungsmodule durch einfaches Lösen der Steckverbindung zu den Steckfassungen und Aufstecken der neuen Steuerung oder des neuen Steuerungsmoduls ausgetauscht werden, wofür nur wenig Zeit benötigt wird im Gegensatz zum Lösen aller zugehöriger Anschlussleitungen und Anschließen der entsprechenden Anschlussleitungen direkt an die neue elektronische Steuerung oder das neue elektronische Steuerungsmodul.

Erfindungsgemäß weist die Verdrahtungsleiterplatte Leiterbahnen in mindestens zwei, vorzugsweise mehreren Lagen auf, sodass die Verdrahtungsleiterplatte möglichst kompakt aufgebaut ist.

Bei einer vorteilhaften Weiterbildung sind auf beiden Seiten der Verdrahtungsleiterplatte Steckfassungen angeordnet, um die elektronischen Steuerungen oder die elektronischen Steuerungsmodule möglichst kompakt auf der Verdrahtungsleiterplatte anordnen zu können.

Mehrere elektronische Steuerungen oder Steuerungsmodule können vorzugsweise über ein auf der Verdrahtungsleiterplatte angeordnetes Bussystem oder auch extern über Steckbrücken miteinander verbunden werden, um die entsprechende Funktionalität einer kompakten Steuerung abzubilden.

Falls die elektronische Steuerung oder das elektronische Steuerungsmodul nicht direkt in die Steckfassung einsteckbar sind, da sie bspw. Klemmanschlüsse zum Anschluss für die Anschlussleitungen aufweisen, ist vorzugsweise eine Adapterplatte vorgesehen, welche eine Leiterplatte mit wenigstens zwei Stiften, die in die Anschlüsse für die Anschlussleitungen der elektronischen Steuerung oder des elektronischen Steuerungsmoduls einführbar sind, und einem Steckverbinder, welcher in die Steckfassung einsteckbar ist, aufweist, um auf diese Art und Weise die elektronische Steuerung oder das elektronische Steuerungsmodul steckbar auszubilden, sodass es auf einfache Art und Weise in die Steckfassung der Verdrahtungsleiterplatte einsteckbar ist.

Die Erfindung wird anhand der folgenden Figuren ausführlich erläutert. Es zeigt:
- Fig. 1: eine Steuerung gemäß dem Stand der Technik und
- Fig. 2: eine Steuerung mit einer Verdrahtungsleiterplatte gemäß der Erfindung.

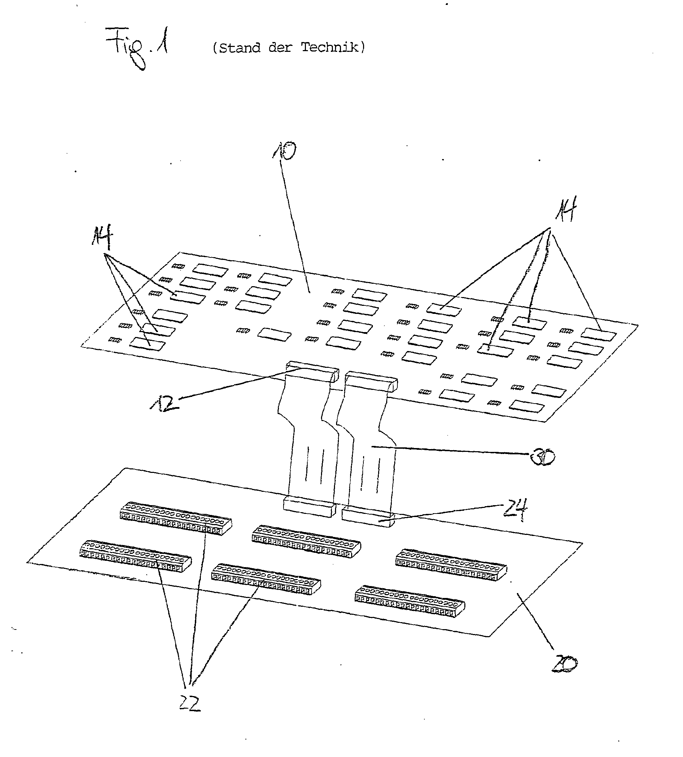

Fig. 1 zeigt eine Steuerung einer Gebäudeautomatisierung gemäß dem Stand der Technik. Diese Steuerung weist zwei Baugruppen auf, nämlich eine Elektronikleiterplatte 10 und eine Anschlussleiterplatte 20. Die Elektronikleiterplatte 10 zeigt mehrere Elektronikbausteine 14, welche die eigentliche Steuerung aufweisen, wobei die Elektronikleiterplatte 10 über einen Steckverbinder 12 entweder direkt oder über ein Verbindungskabel 30 mit einem auf der Anschlussleiterplatte 20 angeordneten Gegenstecker 24 verbindbar ist. Auf der Anschlussleiterplatte 20 sind mehrere Anschlussklemmen 22 angeordnet, in welchen nicht dargestellte Anschlussleitungen angeklemmt werden können, wobei von jeder Anschlussklemme 22 entsprechende Leiterbahnen auf der Anschlussleiterplatte 20 zu dem Gegenstecker 24 führen, welche über das Verbindungskabel 30 mit dem Steckverbinder 12 in elektrisch leitender Verbindung stehen, und wobei ausgehend von dem Steckverbinder 12 auf der Elektronikleiterplatte 10 entsprechende Leiterbahnen derart angeordnet sind, dass die in die Anschlussklemmen 22 eingeführten Anschlussleitungen in elektrisch leitender Verbindung mit den zugehörigen Elektronikbausteinen 14 stehen.

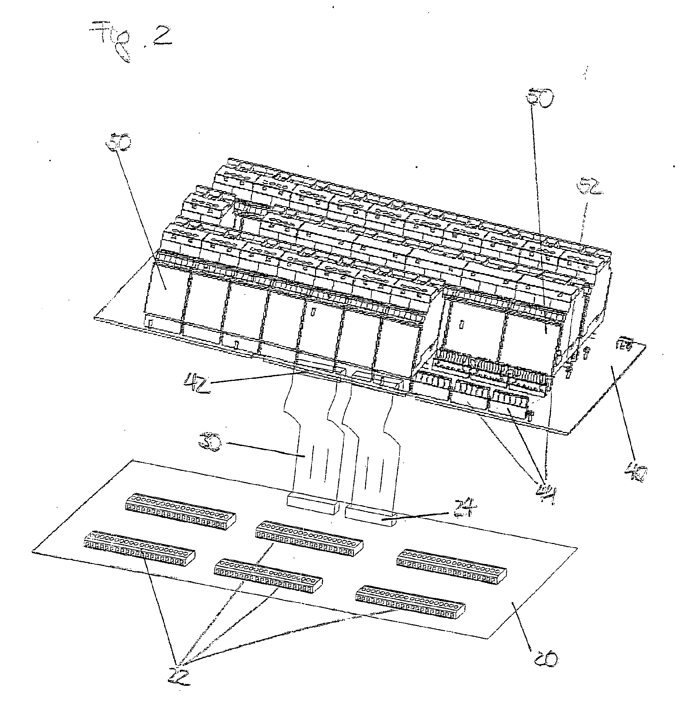

Da heutzutage derartige Elektronikleiterplatten 10 nicht mehr hergestellt werden, sondern lediglich, wie in Fig. 2 dargestellt, einzelne Steuerungen oder einzelne Steuerungsmodule 50 hergestellt werden, ist es heutzutage bei Ausfall eines Elektronikbausteines 14 der Elektronikleiterplatte 10 vonnöten, die in den Anschlussklemmen 22 angeschlossenen Anschlussleitungen sämtlich zu entfernen und direkt in die Steuerungsmodule 50 bspw. ebenfalls über Anschlussklemmen anzuschließen.

Da ein derartiges Lösen sämtlicher Anschlussleitungen aus den Anschlussklemmen 22 jedoch sehr zeitaufwändig ist und zu langen Ausfällen der durch die Steuerung gesteuerten Komponenten der Gebäuden führen kann, ist gemäß der Erfindung, wie in Fig. 2 dargestellt, eine Verdrahtungsleiterplatte 40 vorgesehen, welche einen mit dem Gegenstecker 24 bzw. dem Verbindungskabel 30 kompatiblen Steckverbinder 42 aufweist. Auf der Verdrahtungsleiterplatte 40 sind mehrere Steckfassungen 44 vorgesehen, in welche die Steuerungsmodule 50 insbesondere über einen Steckverbinder 52 einsteckbar sind. Die Steuerungsmodule 50 können entweder direkt einen Steckverbinder 52 aufweisen oder über eine Adapterplatte steckbar ausgestaltet werden. Die Adapterplatte weist bspw. eine Leiterplatte auf, an welcher der Steckverbinder 52 und mehrere Stifte angeordnet sind, wobei die Stifte in die für die Anschlussleitungen vorgesehenen Anschlussklemmen der Steuerungsmodule 50 einsteckbar sind. Über die Leiterplatte sind die Stifte mit dem Steckverbinder 52 elektrisch leitend verbunden. Die Steuerungsmodule 50 werden über die Steckverbinder 53 in die Steckfassungen 44 gesteckt, wodurch ein elektrisch leitender Kontakt hergestellt wird.

Zwischen den Steckfassungen 44 und dem Steckverbinder 42 sind auf der Verdrahtungsleiterplatte 40 entsprechend Leiterbahnen vorgesehen, die die elektrisch leitende Verbindung zwischen der Steckfassung 44 über den Steckverbinder 42 und den Gegenstecker 24 zu der entsprechenden Anschlussklemme 22 auf der Anschlussleiterplatte 20 herstellen.

Falls bei einer Gebäudesanierung somit die Elektronikleiterplatte 10 gemäß dem Stand der Technik ausgetauscht werden muss, kann eine Verdrahtungsleiterplatte 40 mit den entsprechenden Steuerungsmodulen 50 vorbereitet werden, sodass in kürzester Zeit lediglich die Verbindung zwischen dem herkömmlichen Steckverbinder 12 der Elektronikleiterplatte 10 und dem Verbindungskabel 30 gelöst werden muss und das Verbindungskabel 30 an den Steckverbinder 42 der Verdrahtungsleiterplatte 40 angeschlossen werden kann. Ein zeitaufwändiges Lösen sämtlicher in den Anschlussklemmen 22 geklemmter Anschlussleitungen und ein Neuanschließen dieser Anschlussleitungen in den Steuerungsmodulen 50 entfällt vollständig. Der Austausch der herkömmlichen Steuerungen wird somit auf ein Mindestmaß reduziert, wobei Verdrahtungsfehler durch Tauschen von in den Anschlussklemmen 22 gehaltenen Anschlussleitungen ausgeschlossen werden. Falls auch in Zukunft eines der Steuerungsmodule 50 ausfallen sollte oder durch ein moderneres Steuerungsmodul 50 ersetzt werden sollte, kann dieses Steuerungsmodul 50 auf einfache Art und Weise aus der Steckfassung 44 gelöst werden und durch ein neues Steuerungsmodul 50, welches lediglich in die Steckfassung 44 eingesteckt wird, ersetzt werden. Die bereits vorhandenen Verdrahtungen bleiben erhalten, sodass der Austausch in kürzester Zeit vorgenommen werden kann. Ein zeitaufwändiges neues Verdrahten entfällt dann.

Die Verbindung der einzelnen Steuerungsmodule 50 kann entweder über die Verdrahtungsleiterplatte 40 erfolgen, indem auf der Verdrahtungsleiterplatte 40 ein entsprechendes Bussystem vorgesehen ist. Alternativ können die Steuerungsmodule 50 auch über externe Steckbrücken, die in entsprechende Steckverbinder der Steuerungsmodule 50 eingesteckt werden, miteinander verbunden werden, um eine entsprechende Steuerung zu bilden.

Bei der in Fig. 2 dargestellten Verdrahtungsleiterplatte 40 sind sämtliche Steckfassungen 44 auf einer Seite der Verdrahtungsleiterplatte 40 angeordnet. Um eine möglichst kompakte Bauweise zu erzielen, ist es jedoch grundsätzlich möglich, auf der Rückseite der Verdrahtungsleiterplatte 40 weitere Steckfassungen 44 vorzusehen.

### Bezugszeichenliste

- 10: Elektronikleiterplatte
- 12: Steckverbinder
- 14: Elektronikbaustein
- 20: Anschlussleiterplatte
- 22: Anschlussklemme
- 24: Gegenstecker
- 30: Verbindungskabel
- 40: Verdrahtungsleiterplatte
- 42: Steckverbinder
- 44: Steckfassung
- 50: Steuerungsmodul
- 52: Steckverbinder

## Patentansprüche

1. Verdrahtungsleiterplatte (40) zur Verbindung einer elektronischen Steuerung oder eines elektronischen Steuerungsmoduls (50) mit einer Anschlussleiterplatte (20), an welcher in Anschlussklemmen (22) Anschlussleitungen für die elektronische Steuerung oder das elektronische Steuerungsmodul (50) anschließbar sind, wobei die Verdrahtungsleiterplatte (40) einen Steckverbinder (42), welcher direkt oder über ein Verbindungskabel (30) in einen Gegenstecker (24) der Anschlussleiterplatte (20), welcher in elektrisch leitender Verbindung mit den Anschlussklemmen (22) der Anschlussleiterplatte (20) steht, einsteckbar ist, und wenigstens eine Steckfassung (44), in welche die elektronische Steuerung oder das elektronische Steuerungsmodul (50) einsteckbar ist, aufweist, wobei über die Verdrahtungsleiterplatte (40) der Steckverbinder (42) mit der wenigstens einen Steckfassung (44) elektrisch leitend verbunden ist.

2. Verdrahtungsleiterplatte nach Anspruch 1,
**dadurch gekennzeichnet, dass**
die Verdrahtungsleiterplatte (40) Leiterbahnen in mindestens zwei, vorzugsweise mehreren, Lagen aufweist.

3. Verdrahtungsleiterplatte nach einem der vorhergehenden Ansprüche,
**dadurch gekennzeichnet, dass**
auf beiden Seiten der Verdrahtungsleiterplatte (40) Steckfassungen (44) angeordnet sind.

4. Verdrahtungsleiterplatte nach einem der vorhergehenden Ansprüche,
**dadurch gekennzeichnet, dass**
auf der Verdrahtungsleiterplatte (40) mehrere elektronische Steuerungen oder Steuerungsmodule (50) über ein Bussystem miteinander verbunden sind.

5. Verdrahtungsleiterplatte nach einem der vorhergehenden Ansprüche,
**dadurch gekennzeichnet, dass**
mehrere elektronische Steuerungen oder Steuerungsmodule (50) über Steckbrücken miteinander verbunden sind.

6. Verdrahtungsleiterplatte nach einem der vorhergehenden Ansprüche,
**dadurch gekennzeichnet, dass**
die elektronische Steuerung oder das wenigstens eine elektronische Steuerungsmodul (50) über eine Adapterplatte, welche eine Leiterplatte mit wenigstens zwei Stiften, welche in Anschlüsse für die Anschlussleitungen der elektronischen Steuerung oder des elektronischen Steuerungsmoduls (50) einführbar sind, und einem Steckverbinder (52), welcher in die Steckfassung (44) einsteckbar ist, aufweist, in die Steckfassung (44) einsteckbar ist.
